# EUROPÄISCHE PATENTSCHRIFT

(11) **EP 2 993 384 B1**
(45) Veröffentlichungstag und Bekanntmachung des Hinweises auf die Patenterteilung: **24.04.2019**
(21) Anmeldenummer: 15175821.6
(22) Anmeldetag: 08.07.2015
(51) Int. Cl.: F21K 9/90, F21S 4/00, H05K 1/02, F21K 9/232, F21S 4/22, F21Y 115/10, F21Y 103/10, F21Y 107/00, H05K 1/05, H05K 1/18

(54) **BANDFÖRMIGE LEUCHTMITTELVORRICHTUNG, LAMPE UND VERFAHREN ZUM HERSTELLEN DER BANDFÖRMIGEN LEUCHTMITTELVORRICHTUNG**
TAPE-FORM ILLUMINANT DEVICE, LAMP AND METHOD FOR PRODUCING THE TAPE-FORM ILLUMINANT DEVICE
DISPOSITIF D'ECLAIRAGE EN FORME DE BANDE, LAMPE ET PROCEDE DE FABRICATION DE DISPOSITIF D'ECLAIRAGE EN FORME DE BANDE

(30) Priorität: 11.07.2014 DE 102014213561
(43) Veröffentlichungstag der Anmeldung: 09.03.2016
(73) Patentinhaber: vosla GmbH, 08523 Plauen (DE)
(72) Erfinder: WINKLER, Markus, 97941 Tauberbischofsheim (DE); ENENKEL, Martin, 04416 Markkleeberg (DE)
(74) Vertreter: Isarpatent

(56) Entgegenhaltungen:
- WO-A2-2010/040645
- DE-A1-102009 009 288
- DE-U1-202013 009 434
- US-A1- 2011 096 545
- US-A1- 2011 188 248

## Beschreibung

### GEBIET DER ERFINDUNG

Die vorliegende Erfindung betrifft eine bandförmige Leuchtmittelvorrichtung, sowie eine Lampe mit wenigstens einer derartigen bandförmigen Leuchtmittelvorrichtung, wobei die Lampe insbesondere eine LED-basierte Lampe ist. Die LED-basierte Lampe kann hierbei beispielsweise als so genannte Retrofit-Lampe ausgebildet sein. Des Weiteren betrifft die Erfindung ein Verfahren zum Herstellen der bandförmigen Leuchtmittelvorrichtung.

### TECHNISCHER HINTERGRUND

Für den Ersatz von Glühlampen werden zunehmend auf Leuchtdioden (LED) basierende Lampen eingesetzt. Unter einer Leuchtdiode oder kurz LED ist ein lichtemittierendes Halbleiterbauelement zu verstehen, dessen elektrische Eigenschaften denen einer Diode entsprechen.

Aus der EP 2 535 640 A1 ist eine LED-Lampe mit einem Licht emittierenden LED-Streife bekannt. Der Licht emittierende LED-Streifen weist ein transparentes Substrat auf, auf welchem LED-Chips angeordnet sind, welche in Reihe geschaltet sind. Das transparente Substrat ist aus Glas, Hartglas, Quartzglas, transparenter Keramik oder Kunststoff hergestellt. Ein derartiger starrer LED-Streifen hat jedoch den Nachteil, dass seine Länge durch die Länge der LED-Lampe begrenzt wird und damit auch die Zahl an LED-Chips, mit welchen der LED-Streifen bestückbar ist. Um eine hohe Lichtleistung und eine gleichmäßig Abstrahlung zu erzielen ist jedoch in der Regel eine größere Anzahl an LED-Chips notwendig.

Des Weiteren ist in der WO 2011/098358 A1 eine Lampe beschrieben, welche ein zylindrisches Gefäß aus Glas aufweist. In dem zylindrischen Gefäß ist ein Träger mit darauf in Reihe montierten LEDs vorgesehen. Der Träger, der aus einem Platinenmaterial, beispielsweise FR4 oder MCPCB, hergestellt ist, ist mit Haltedrähten an dem Gefäß befestigt, so dass die LEDs die komplette Gefäßwand direkt oder indirekt ausleuchten können. Der Träger mit LEDs weist jedoch ebenfalls den Nachteil auf, dass seine Länge durch die Länge des zylindrischen Gefäßes begrenzt wird.

Aus der DE 10 2009 009 288 A1 ist außerdem eine starrflexible Trägerplatte zur Befestigung mindestens einer Halbleiter-Lichtquelle bekannt. Die starrflexible Trägerplatte weist mindestens einen starren Trägerbereich zur Befestigung der mindestens einen Halbleiter-Lichquelle und einen flexiblen Trägerbereich auf, wobei der flexible Trägerbereich durch Abdünnung eines starren Trägerbereichs erzeugt worden ist.

Des Weiteren ist aus der DE 20 2013 009434 A1 ein Lampe, insbesondere Retrofit-Lampe, bekannt, mit einem Lampensockel, mit einer mit dem Lampensockel verbundenen, zumindest teiltransparenten geschlossenen Hülle, welche derart ausgebildet ist, als Kühlkörper für die Lampe zu fungieren, mit einer Leuchtmittelanordnung, welche eine Vielzahl von optoelektronischen Bauelementen enthält, die innerhalb der Hülle derart in einer 4n-Anordnung angeordnet sind, dass sie in alle Raumrichtungen wirken.

In der US 2011/188248 A1 ist eine Lampenstreifen-Abdeckstruktur offenbart, die eine erste Leitung, eine zweite Leitung, einen Isolierkörper, LEDs und eine thermoplastische Folie aufweist. Der Isolierkörper ist entsprechend der ersten Leitung und der zweiten Leitung mit Mulden versehen, wodurch ein erster Verbindungsabschnitt der ersten Zuleitung und ein zweiter Verbindungsabschnitt der zweiten Leitung freigelegt wird. Die LEDs sind mit dem ersten Verbindungsabschnitt und dem zweiten Verbindungsabschnitt elektrisch verbunden. Die thermoplastische Folie umschließt die LEDs und den Isolierkörper, um die LEDs und den Isolierkörper aufgrund einer thermischen Schrumpfung zu bedecken.

Aus der US 2011/096545 A1 ist weiter eine LED-Beleuchtungsleiste bekannt, die einen ersten leitfähigen Draht, einen zweiten leitfähigen Draht parallel zu dem ersten leitfähigen Draht, einen Isolator, mindestens eine LED und einen Befestigungsrahmen umfasst. Der Isolator weist eine obere Schicht und eine untere Schicht auf, die den ersten leitfähigen Draht und den zweiten leitfähigen Draht abdecken

WO 2010/040645 A2 offenbart eine bandförmige Leuchtmittelvorrichtung für eine Lampe gemäß der Präambel vom unabhängigen Anspruch 1.

### ZUSAMMENFASSUNG DER ERFINDUNG

Vor diesem Hintergrund liegt der vorliegenden Erfindung die Aufgabe zugrunde, eine verbesserte bandförmige Leuchtmittelvorrichtung bereitzustellen, und insbesondere eine bandförmige Leuchtmittelvorrichtung welche den von der Lampe vorgegebenen Bauraum besser ausnutzen kann.

Erfindungsgemäß wird diese Aufgabe durch eine bandförmige Leuchtmittelvorrichtung mit den Merkmalen des Patentanspruchs 1, eine Lampe mit wenigstens einer derartigen bandförmigen Leuchtmittelvorrichtung gemäß dem Patentanspruch 12 und ein Verfahren zum Herstellen der bandförmigen Leuchtmittelvorrichtung gemäß dem Patentanspruch 13 gelöst.

Demgemäß ist eine bandförmige Leuchtmittelvorrichtung für eine Lampe, insbesondere LED-Lampe, vorgesehen aufweisend: ein Substrat, welches wenigstens einen ersten Abschnitt und wenigstens einen zweiten Abschnitt bildet, wobei der erste Abschnitt gegenüber dem zweiten Abschnitt eine reduzierte Biegesteifigkeit aufweist durch Aufbringen wenigstens eines zusätzlichen Materials auf den wenigstens einen zweiten Abschnitt, wobei die bandförmige Leuchtmittelvorrichtung in dem wenigstens einen ersten Abschnitt mit der reduzierten Biegesteifigkeit derart gebogen ist, dass die bandförmigen Leuchtmittelvorrichtung eine dreidimensionale Form annimmt, wobei die Leuchtmittelvorrichtung wenigstens ein optoelektronisches Bauelement aufweist, welches auf dem wenigstens einen zweiten Abschnitt angeordnet ist und wobei die bandförmige Leuchtmittelvorrichtung eine Hülle aufweist.

Die Erkenntnis der vorliegenden Erfindung besteht darin, dass durch eine gezielte Reduzierung der Biegesteifigkeit in wenigstens einem Abschnitt der bandförmigen Leuchtmittelvorrichtung, diese in eine dreidimensional oder räumliche Form bringbar ist. Durch diese dreidimensionale oder räumliche Form oder Struktur der bandförmigen Leuchtmittelvorrichtung kann diese den durch eine Lampe und deren Hülle oder Lampenkolben vorgegebenen Bauraum besser ausnutzen, im Gegensatz zu den flachen streifenförmigen Trägern mit darauf montierten LEDs im zuvor beschriebenen Stand der Technik. Der wenigstens eine zweite Abschnitt der bandförmigen Leuchtmittelvorrichtung wird dagegen nicht gebogen und kann stattdessen beispielsweise zum Befestigen von elektronischen Bauelementen, wie optoelektronischen Bauelementen, Treibern, Wandlern, Dioden, Zener-Dioden usw. genutzt werden. Dadurch, dass der zweite Abschnitt nicht extra gebogen wird, wie der erste Abschnitt werden auf ihm montierte Bauelemente auch nicht beeinträchtigt oder eventuell beschädigt.

Des Weiteren wird eine Lampe mit wenigstens einer derartigen bandförmigen Leuchtmittelvorrichtung vorgesehen.

Außerdem wird ein Verfahren zur Herstellung einer derartigen bandförmigen Leuchtmittelvorrichtung bereitgestellt, wobei das Verfahren die Schritte aufweist:
Bereitstellen einer ebenen bandförmigen Leuchtmittelvorrichtung als Ausgangsform, wobei die bandförmige Leuchtmittelvorrichtung wenigstens einen ersten Abschnitt und wenigstens einen zweiten Abschnitt aufweist,
Ausbilden des wenigstens einen ersten Abschnitts mit einer gegenüber dem wenigstens einen zweiten Abschnitt reduzierten Biegesteifigkeit, und
Biegen des wenigstens einen ersten Abschnitts derart, dass die ebene bandförmige Leuchtmittelvorrichtung eine dreidimensionale Form aufweist.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß der Erfindung weist die Leuchtmittelvorrichtung wenigstens ein optoelektronisches Bauelement auf, welches auf dem zweiten Abschnitt angeordnet ist. Das optoelektronische Bauelement ist beispielsweise ein LED-Chip. In einer Ausführungsform der Erfindung ist der zweite Abschnitt ungebogen oder im Wesentlichen ungebogen. Dadurch kann die Leuchtmittelvorrichtung einerseits durch Umbiegen lediglich des wenigstens einen ersten Abschnitts eine dreidimensionale Form annehmen, ohne dass ein optoelektronisches Bauelement oder ein anderes elektronisches Bauelement welches auf einem zweiten Abschnitt vorgesehen ist, beeinträchtigt oder gar beschädigt wird.

Gemäß der Erfindung weist die Leuchtmittelvorrichtung ein Substrat auf, welches den wenigstens einen ersten Abschnitt und den wenigstens einen zweiten Abschnitt bildet. In einer weiteren Ausführungsform der Erfindung ist der wenigstens eine erste Abschnitt dabei plastisch und/oder elastisch verformbar. Der verformte erste Abschnitt kann dabei durch ein Fixierungsmittel im Fall einer elastischen Verformung in seiner gebogenen Form fixiert oder im Fall einer plastischen Verformung zusätzlich fixiert werden. Das Fixierungsmittel ist dabei beispielsweise zumindest teiltransparent. Des Weiteren kann das Fixierungsmittel aushärtbar sein. Als Fixierungsmittel wird z.B. ein Epoxidharz, Silikon oder ein silikonhaltiges Material eingesetzt.

In noch einer weiteren Ausführungsform der Erfindung ist das Substrat aus Metall, einer Metalllegierung, einem mehrlagigen Metallstreifen, und/oder einem Kunststoff hergestellt. In einem Ausführungsbeispiel weist das Substrat eine hohe Wärmeleitfähigkeit auf. Dies hat den Vorteil, dass die Wärme im Falle von auf dem Substrat vorgesehenen LED-Chips besser abgeführt werden kann.

Gemäß einer Ausführungsform der Erfindung ist der erste Abschnitt zwischen zwei zweiten Abschnitten vorgesehen. Auf den beiden zweiten Abschnitten angeordnete optoelektronische Bauelemente können beispielsweise über einen Bonddraht miteinander elektrisch verbunden werden. Der Bonddraht weist dabei eine ausreichende Länge auf, um zu ermöglichen, dass der dazwischen angeordnete erste Abschnitt umgebogen werden kann.

In einer Ausführungsform der Erfindung ist der erste Abschnitt mit einem gegenüber dem zweiten Abschnitt reduzierten Querschnitt ausgebildet. Der Querschnitt des ersten Abschnitts ist dabei in der Breite und/oder der Dicke reduziert. Dadurch kann der erste Abschnitt sehr einfach und kostengünstig mit der reduzierten Biegesteifigkeit gegenüber dem zweiten Abschnitt ausgebildet werden. Der Querschnitt des ersten Abschnitts des Substrats kann hierbei in seiner Breite und/oder Dicke gegenüber dem zweiten Abschnitt des Substrats um wenigstens 10% und insbesondere um wenigstens 50% reduziert werden. Auf diese Weise kann der erste Abschnitt einerseits leicht umgebogen werden und andererseits eine weiterhin zuverlässige Verbindung zu dem zweiten Abschnitt bereitstellen. Ebenso kann die Biegesteifigkeit des ersten Abschnitts des Substrats gegenüber der Biegesteifigkeit des zweiten Abschnitts um wenigstens 10% oder insbesondere um wenigstens 50% reduziert werden.

In einer anderen Ausführungsform der Erfindung ist die Biegesteifigkeit des ersten Abschnitts gegenüber der Biegesteifigkeit des zweiten Abschnitts des Substrats reduziert durch Ändern der Materialeigenschaft des ersten Abschnitts oder zweiten Abschnitts. Zur Änderung der Materialeigenschaft und zum Ändern der Biegesteifigkeit des ersten Abschnitts gegenüber der Biegesteifigkeit des zweiten Abschnitts des Substrats, kann das Substrat aus Metall oder einer Metalllegierung hergestellt und durch Weichglühen beispielsweise des ersten Abschnitts dessen Biegesteifigkeit reduziert werden.

Gemäß der Erfindung wird die Biegesteifigkeit des zweiten Abschnitts gegenüber der Biegesteifigkeit des ersten Abschnitts des Substrats erhöht durch Aufbringen wenigstens eines zusätzlichen Materials auf den zweiten Abschnitt. Dadurch kann die Biegesteifigkeit des zweiten Abschnitts erhöht und dem zufolge die Biegesteifigkeit des ersten Abschnitts dagegen reduziert werden gegenüber dem zweiten Abschnitt. Das zusätzliche Material ist beispielsweise ein Metall, ein Kunststoff, z.B. eine Kunststofffolie oder eine Kunststoffbeschichtung, oder eine Keramik.

In einer weiteren Ausführungsform der Erfindung ist das zusätzliche Material elektrisch isolierend und derart auf dem zweiten Abschnitt aufgebracht, dass wenigstens ein auf dem zweiten Abschnitt vorgesehenes elektronisches Bauelement, insbesondere ein optoelektronisches Bauelement gegenüber dem Substrat elektrisch isoliert ist.

In noch einer weiteren Ausführungsform der Erfindung ist der erste Abschnitt, welcher zwischen zwei zweiten Abschnitten liegt, derart ausgebildet, dass er einen oder mehrere Verbindungsstege zu den beiden zweiten Abschnitten bildet. Mehrere Verbindungsstege sind ebenfalls leicht zu realisieren und stellen ebenfalls einen ersten Abschnitt mit einer reduzierten Biegesteifigkeit bereit.

Gemäß einer Ausführungsform der Erfindung ist die bandförmige Leuchtmittelvorrichtung beispielsweise mit einer Spiralform, einer runden Form, einer Sternform, einer ovalen Form und/oder einer eckigen Form als dreidimensionaler Form ausgebildet.

Gemäß der Erfindung weist die bandförmige Leuchtmittelvorrichtung eine Hülle auf. Eine solche Hülle hat den Vorteil, dass sie das Substrat und die darauf montieren elektronischen Bauelemente vor Beschädigung schützt. Die Hülle ist dabei steif oder biegsam ausgebildet, je nach Funktion und Einsatzzweck.

In einer anderen Ausführungsform der Erfindung weist die bandförmige Leuchtmittelvorrichtung an ihren Enden jeweils einen elektrischen Kontakt auf. Wenigstens ein elektrischer Kontakt ist dabei mit dem wenigstens einen optoelektronischen Bauelement durch eine Verbindungsleitung elektrisch verbunden. Die Verbindungsleitung ist z.B. ein Bonddraht oder eine Leiterbahn des Substrats ist. Ebenso sind wenigstens zwei optoelektronische Bauelemente durch eine Verbindungsleitung miteinander elektrisch verbunden. Die Verbindungsleitung ist dabei ebenfalls z.B. ein Bonddraht oder eine Leiterbahn des Substrats.

In einer weiteren Ausführungsform der Erfindung ist auf wenigstens einer der zweiten Abschnitte wenigstens ein zusätzliches elektronisches Bauteil montiert, beispielsweise ein Treiber, ein Wandler, eine Zener-Diode usw..

In noch einer weiteren Ausführungsform der Erfindung ist das Substrat als Streifen, Draht oder Halbleiterkörper ausgebildet. Wenigstens ein erster Abschnitt des Halbleiterkörpers kann dabei ausreichend dünn ausgebildet werden, um gebogen oder umgebogen zu werden.

Das Biegen der bandförmige Leuchtmittelvorrichtung kann gemäß einer Ausführungsform der Erfindung mittels eines Kerns oder kernlos durch einen Biegeautomat erfolgen.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: eine Seitenansicht einer bandförmigen Leuchtmittelvorrichtung gemäß einer ersten Ausführungsform der Erfindung in einer Endform;
- Fig. 2: eine Seitenansicht einer bandförmigen Leuchtmittelvorrichtung gemäß einer zweite Ausführungsform der Erfindung, wobei die bandförmige Leuchtmittelvorrichtung in der Ausgangsform gezeigt ist;
- Fig. 3: eine Draufsicht auf die bandförmige Leuchtmittelvorrichtung gemäß Fig. 2;
- Fig. 4: eine Seitenansicht einer bandförmigen Leuchtmittelvorrichtung gemäß einer dritten Ausführungsform der Erfindung, wobei die bandförmige Leuchtmittelvorrichtung in der Ausgangsform gezeigt ist;
- Fig. 5: eine Prinzipdarstellung einer Lampe mit einer erfindungsgemäßen bandförmigen Leuchtmittelvorrichtung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist - jeweils mit denselben Bezugszeichen versehen.

### BESCHREIBUNG VON AUSFÜHRUNGSBEISPIELEN

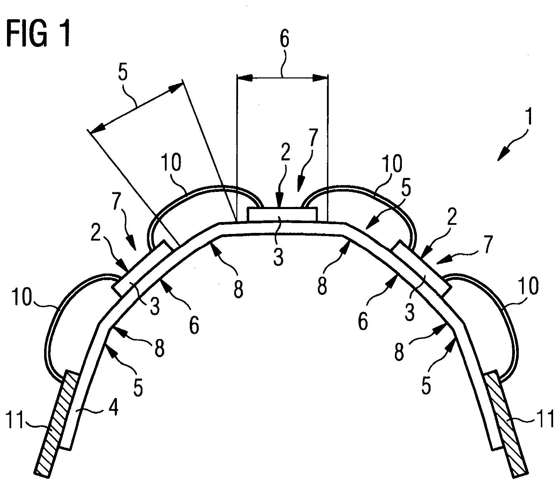

Fig. 1 zeigt eine Seitenansicht einer bandförmigen Leuchtmittelvorrichtung 1 gemäß einer ersten Ausführungsform der Erfindung in einer dreidimensionalen Form oder Endform.

Die bandförmige Leuchtmittelvorrichtung 1 weist dabei mehrere optoelektronische Bauelemente 2 auf. In dem in Fig. 1 gezeigten Ausführungsbeispiel ist das jeweilige optoelektronische Bauelement 2 als Leuchtdiode ausgebildet. Unter einer Leuchtdiode oder kurz "LED" vom Englischen "light emitting diode", (Deutsch: "lichtemittierende Diode") ist ein lichtemittierendes Halbleiterbauelement zu verstehen, dessen elektrische Eigenschaften denen einer Diode entsprechen. Fließt durch die Diode elektrischer Strom in Durchlassrichtung, so strahlt sie Licht, Infrarotstrahlung oder auch UV-Strahlung mit einer vom Halbleitermaterial und der Dotierung des jeweils verwendeten Halbleitermaterials abhängigen Wellenlänge ab.

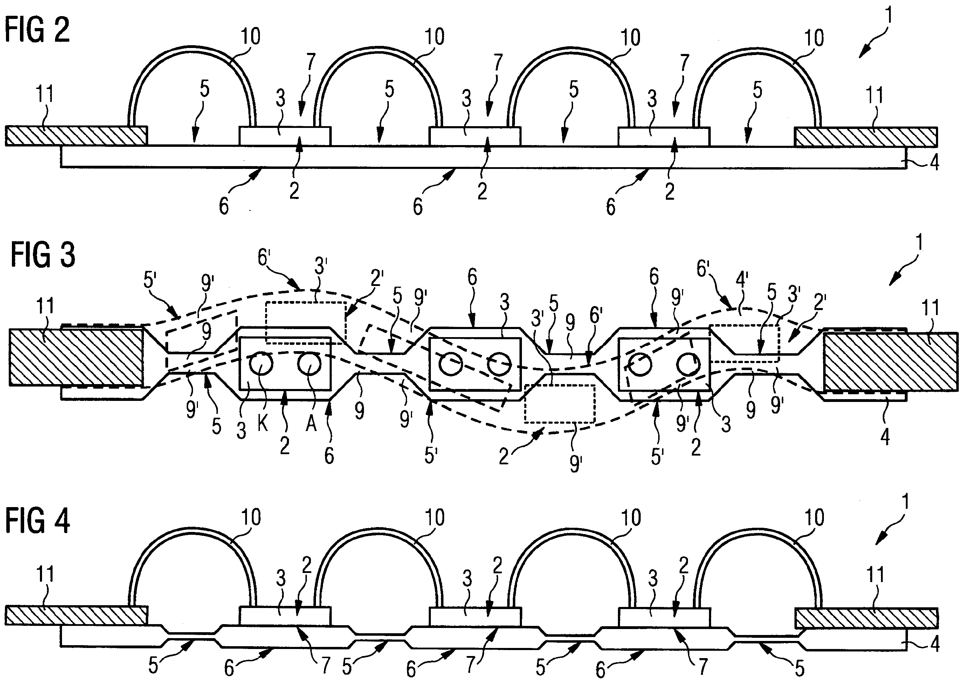

Die im Folgenden kurz LEDs oder LED-Chip 3 genannten Leuchtdioden sind dabei als ein Beispiel für optoelektronische Bauelemente 2 auf einem Substrat 4 angeordnet. Die bandförmige Leuchtmittelvorrichtung 1 mit dem Substrat 4 und den darauf vorgesehenen LED-Chips 3 ist in seiner Ausgangsform zunächst als flaches oder ebenes Band ausgebildet, wie im Folgenden anhand der Fig. 3, 4 und 5 erläutert wird, bevor es in seine Endform gebogen wird, wie in Fig. 1 und nachfolgender Fig. 2 angedeutet ist. In der Endform ist das zuvor flache oder ebene Band gebogen, so dass es eine räumliche oder dreidimensionale Form annimmt. Die LED-Chips 3 sind in der Endform der bandförmigen Leuchtmittelvorrichtung beispielsweise in einer 4π-Anordnung angeordnet, um in alle Raumrichtungen zu wirken.

Im Falle eines als LED oder LED-Chip ausgebildeten optoelektronischen Bauelementes erfolgt das Ausstrahlen von Licht von dem optoelektronischen Bauelement nach außen. Im Falle eines als Sensor ausgebildeten optoelektronischen Bauelementes erfolgt ein Aufnehmen von einem Messparameter, beispielsweise Licht. Die bandförmige Leuchtmittelvorrichtung kann somit sowohl wenigstens ein optoelektronisches Bauelement in Form z.B. eines LED-Chips aufweisen, zum Ausstrahlen von Licht, und/oder wenigstens ein optoelektronisches Bauelement in Form eines Sensors aufweisen, wobei der Sensor z.B. zum Aufnehmen eines Messparameters, wie z.B. Licht, ausgebildet ist.

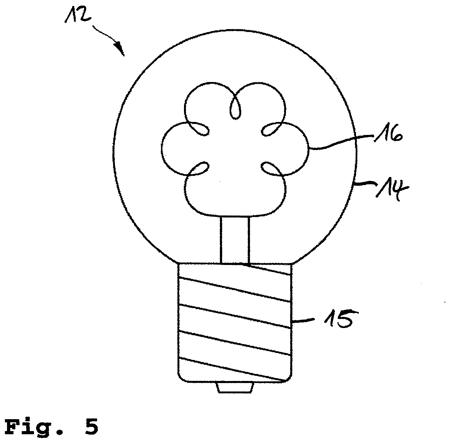

Derartige bandförmige Leuchtmittelvorrichtungen 1 können beispielsweise als Lichtquelle in LED- Retrofit-Lampen eingesetzt werden, wie in nachfolgender Fig. 5 gezeigt ist.

Bei LED Retrofit-Lampen mit streifenförmigen LED Anordnungen werden die LED Chips auf ein Substrat aufgebracht. Das Substrat dient zur Wärmeleitung und gibt die mechanische Festigkeit. Die streifenförmigen LEDs werden dann in der Lampe als Lichtquelle so angeordnet, dass eine möglichst gleichmäßige Abstrahlung in den gesamten Raum erreicht wird. Um die Gleichmäßigkeit zu erhöhen werden transparente oder teiltransparente Substrate wie z.B Glas, Saphir oder Al₂O₃-Keramiken verwendet.

Um eine hohe Lichtleistung und gleichmäßige Abstrahlungen zu erzielen sind dabei große Oberflächen der LED Anordnungen nötig. Um diese zu erreichen werden mehrere der starren stabförmigen LED Streifen elektrisch miteinander verschaltet, mittels einer Parallelschaltung oder Reihenschaltung. Der verfügbare Bauraum in der LED Retrofit-Lampe limitiert dabei die Länge der LED Anordnungen. Die entsprechende Verbindungstechnik zwischen den verschiedenen LED Anordnungen, wie Schweißen, Löten, Klemmen, ist hierbei sehr aufwendig und teuer.

Daher wird die erfindungsgemäße verformbare bandförmige Leuchtmittelvorrichtung 1 bereitgestellt, welche in der Ausgangsform, wie in nachfolgenden Fig. 2, 3 und 4 gezeigt, zunächst eine flache oder ebene bzw. zweidimensionale Anordnung von optroelektronischen Bauelementen 2 auf dem Substrat 4 aufweist. Derartige optoelektronischen Bauelemente 2 sind beispielsweise LEDs oder LED-Chips wie in Fig. 1 und den nachfolgenden Fig. 2, 3 und 4 gezeigt ist oder Sensoren zum Aufnehmen eines Messparameters wie z.B. Licht.

Die auf dem Substrat vorgesehenen optoelektronischen Bauelemente 2, wie LEDs oder LED-Chips, können durch den speziellen Aufbau der erfindungsgemäßen bandförmigen Leuchtmittelvorrichtung 1 später zu einer räumliche oder dreidimensionale Anordnung oder Geometrie umgeformt werden, ohne dass die LEDs oder LED-Chips oder die elektrischen Kontaktierung der LEDs oder LED-Chips beschädigt werden.

Durch die räumliche oder dreidimensionale Verformung der bandförmigen Leuchtmittelvorrichtung 1 beispielsweise zu einer Spirale, kann die Länge der bandförmigen Leuchtmittelvorrichtung 1, die in den Lampen verbaut werden können, signifikant erhöht werden. Dadurch können mehr optoelektronische Bauelemente 2, wie LEDs oder LED Chips usw., auf dem gleichen Substrat angeordnet werden. Demzufolge reduziert sich die Anzahl nötiger elektrische Verbindungen im Gegensatz zur der Verwendung mehrerer kurzer stabförmiger LED Anordnungen. Weiterhin kann durch die räumliche Form der bandförmigen Leuchtmittelvorrichtung 1 die Gleichmäßigkeit der Abstrahlung sowie die verbaubare Menge an optoelektronischen Bauelementen 2, wie LEDs oder LED Chips 3 usw., im vorgegebenen Bauraum einer Lampe erhöht werden. Außerdem kann bei einer geeigneten Gestaltung der dreidimensionalen Form oder Endform der bandförmigen Leuchtmittelvorrichtung 1 eine gleichmäßige Abstrahlcharakteristik der optoelektronischen Bauelemente 3 im Falle von z.B. LED-Chip erzielt und dadurch auf ein transparentes Substrat verzichtet werden. Es kann neben einem opaken oder lichtundurchlässigen Substrat, z.B. aus Metall usw., aber auch ein transparentes oder zumindest teilweise transparentes Substrat eingesetzt werden, je nach Funktion und Einsatzzweck. Dies gilt für alle Ausführungsformen der Erfindung.

Für die Herstellung der bandförmigen Leuchtmittelvorrichtung 1 ergibt sich weiterhin der Vorteil, dass zunächst ein flaches oder ebenes und z.B. sehr langes Substrat 4 hergestellt werden kann, welches erst später in eine dreidimensionale Form oder Struktur überführt wird. Ein sofortiges oder unmittelbares Herstellen eines solchen räumlichen oder dreidimensionalen Substrates und anschließende Platzieren von LEDs oder LED Chips auf diesem Substrat ist wesentlich teurerer und aufwendiger.

Die Grundlage für die Erfindung beruht auf einer gezielten Variation der mechanischen Biegefestigkeit des Substrates 4 der erfindungsgemäßen bandförmigen Leuchtmittelvorrichtung 1, derart, dass die Biegefestigkeit des Substrates 4 in einem ersten Abschnitt 5 oder Bereich zwischen den LED Chips 3 in Fig. 1 geringer ist als in einem zweiten Abschnitt 6 oder Bereich, in welchem die LED Chips 4 auf das Substrat 4 aufgebracht sind. Der Bereich zwischen den elektronischen Bauelementen, z.B. optoelektronische Bauelemente 1 wie LED-Chips 3, bildet jeweils den ersten Abschnitt 5 des Substrats 4 und der jeweilige Bereich auf welchem ein oder mehrere LED-Chips 3 und/oder andere elektronische Bauelemente 7 befestigt werden bildet den zweiten Abschnitt 6.

Auf diese Weise führt, wie in Fig. 1 gezeigt ist, ein Biegemoment zur Verformung des Substrats 4 im Bereich zwischen den LED Chips 3 oder des jeweils ersten Abschnitts 5. Dem entsprechend ist in dem Bereich zwischen den LED Chips 3 als optoelektronischen Bauelementen bzw. im ersten Abschnitt 5 des Substrats 4 ein Biegeradius 8 vorhanden.

Der Bereich des Substrates 4 wo die LED Chips 3 aufgebracht sind, d.h. im zweiten Abschnitt 6 des Substrats 4, wird dagegen nicht zusätzlich gebogen oder verformt. Dem entsprechend ist in dem Bereich wo die LED Chips 3 als optoelektronische Bauelemente 2 auf dem Substrat 4 angebracht sind, d.h. dem zweiten Abschnitt 6 des Substrats 4, kein oder im Wesentlichen kein Biegeradius vorhanden, wie in Fig. 1 angedeutet ist.

In einem Ausführungsbeispiel der erfindungsgemäßen bandförmigen Leuchtmittelvorrichtung 1 ist das Substrat 4 zumindest im ersten Abschnitt 5 oder Bereich zwischen den optoelektronischen Bauelementen 2, z.B. LEDs bzw. LED Chips in Fig. 1, plastisch verformbar. In einem weiteren Ausführungsbeispiel besitzt das Substrat 4 eine hohe Wärmeleitfähigkeit und ist aus Metall, beispielsweise einem Nicht-Eisenmetall.

Das Substrat 4 kann auch aus verschiedenen biegbaren Elementen aufgebaut sein. Beispielsweise kann das Substrat 4 als ein mehrlagiger Metallstreifen aus mehreren Lagen aus Metall und/oder einer Metalllegierung ausgebildet sein. Bei mehreren Lagen aus Metall können zumindest zwei Lagen übereinander oder nebeneinander angeordnet sein. Wenigstens zwei der Lagen des Metallstreifens können aus demselben oder einem unterschiedlichen Metall oder Metalllegierung hergestellt sein, je nach Funktion und Einsatzzweck.

Ebenso kann das Substrat 4 als eine Kombination aus Metall und Kunststoff ausgebildet sein. Der Kunststoff kann dabei z.B. zumindest auf einen Abschnitt eines Metallstreifens aufgebracht und zur Isolierung der optoelektronischen Bauelemente 2, z.B. der LED Chips 3 in Fig. 1, gegenüber dem Substrat 4 dienen. Der Kunststoff kann dabei als Folie aufgebracht oder z.B. um den Metallstreifen gemoldet oder gespritzt sein.

Die reduzierte mechanische Biegesteifigkeit zwischen den optoelektronischen Bauelementen 2, z.B. LED Chips 3, kann auf Grundlage einer Querschnittsverringerung, wie in nachfolgenden 2, 3 und 4 gezeigt ist, und/oder der Änderung der Materialeigenschaften, wie in Fig. 1 angedeutet ist, beruhen. In dem Fall, dass nur die Materialeigenschaft verändert wird, z.B. durch Weichglühen, kann auf eine zusätzliche Querschnittsverringerung verzichtet werden, wie in dem in Fig. 1 gezeigten Ausführungsbeispiel. Grundsätzlich kann aber auch eine Querschnittsverringerung mit einer Änderung der Materialeigenschaft, z.B. durch Weichglühen usw., kombiniert werden.

Die Materialeigenschaften eines Substrats 4, z.B. aus Metall, können beispielweise durch das zuvor genannte Weichglühen verändert oder beeinflusst werden. Die Erfindung ist jedoch auf dieses Beispiel des Weichglühens nicht beschränkt. Grundsätzlich kann jedes Verfahren oder Kombination von Verfahren eingesetzt werden, welches bzw. welche geeignet ist, die Materialeigenschaft des Substrats 4 derart zu verändern, dass die mechanische Biegesteifigkeit zwischen den auf dem Substrat 4 angeordneten optoelektronischen Bauelementen 2 reduziert wird.

Der Querschnitt des Substrats 4 oder die Biegesteifigkeit im ersten Abschnitt 5 oder Bereich zwischen den optoelektronischen Bauelementen 2 kann um mehr als 10% reduziert und in bevorzugten Ausführung um mehr als 50% reduziert werden. Die Querschnittsverringerung des Substrats 4 kann dabei in Breitenrichtung des Substrats 4, wie in nachfolgender Fig. 2 und 3 gezeigt ist, und/oder in Dickenrichtung des Substrats 4 erfolgen, wie in nachfolgender Fig. 4 gezeigt ist. Auf diese Weise kann der Querschnitt des Substrats 4 im ersten Abschnitt 5 oder zwischen jeweils zwei benachbarten auf dem Substrat 4 angeordneten optoelektronischen Bauelementen 2 auf wenigstens einen in der Breite und/oder Dicke verjüngten Verbindungssteg 9 reduziert werden.

Zusätzlich oder alternativ kann zur Schwächung des Substrats 4 im ersten Abschnitt 5 zwischen den optoelektronischen Bauelementen 2, z.B. LED Chips 3, auch die mechanische Festigkeit im zweiten Abschnitt 6 oder Bereich der aufgebrachten optoelektronischen Bauelemente des Substrats 4, erhöht werden durch Aufbringen wenigstens eines zusätzlichen Materials, wie z.B. eines Metalls, einer Metalllegierung, eines Kunststoffs (Plastik) und/oder einer Keramik usw. auf den zweiten Abschnitt 6. Dabei kann der Bereich oder zweite Abschnitt 6 zum Aufbringen z.B. der LEDs oder LED Chips 3 in Fig. 1 teilweise oder komplett von dem zusätzlichen Material umschlossen oder damit beschichtet sein, derart, dass das Material, beispielsweise ein Kunststoff oder eine Keramik usw., zusätzlich als Isolator oder elektrische Isolierung zwischen den LEDs bzw. LED Chips 3 und dem Substrat 4 dient.

Durch die geringere Biegesteifigkeit im ersten Abschnitt 5 oder im Bereich zwischen den optoelektronischen Bauelementen 2, wie z.B. LEDs oder LED Chips 3 in Fig. 1, wird beim Biegen des Substrats 4 das Biegemoment durch eine Verformung der bandförmigen Leuchtmittelvorrichtung 1 zwischen den optoelektronischen Bauelementen 2 abgefangen. Die empfindlichen optoelektronischen Bauelemente 2 werden dagegen nicht oder wesentlich weniger belastet. Eine Beschädigung der optoelektronischen Bauelemente 2 wird durch das Biegen des Substrats 4 damit verhindert. Es entsteht eine bandförmige Leuchtmittelvorrichtung 1 mit einer Geometrie mit gebogenen ersten Abschnitten 5 und nicht gebogenen zweiten Abschnitten 6, auf welchen elektronische Bauelemente 7 und insbesondere optoelektronische Bauelemente 2 angeordnet werden können.

Die elektrische Kontaktierung der optoelektronischen Bauelemente 2, z.B. LEDs oder LED Chips 3 in Fig. 1, kann entweder durch Verbindungsleitungen, wie z.B. Bonddrähte 10, und/oder durch Leiterbahnen auf dem Substrat 4, beispielsweise unter Verwendung der Thin Film Flip Chip (FFFC) Technologie, erfolgen.

Bei der elektrischen Kontaktierung durch einen Bonddraht 10, wie in Fig. 1 und nachfolgenden Fig. 2, 3 und 4 angedeutet ist, muss die Länge des Bonddrahtes 10 geeignet verlängert werden. Die Länge des Bonddrahts 10, welcher zwei optoelektronische Bauelemente 2 in Fig. 1 und nachfolgenden Fig. 2, 3 und 4 verbindet, muss derart verlängert werden, dass beim Biegen, wie in Fig. 1 gezeigt ist, der sich vergrößernde Abstand zwischen den beiden durch den Bonddraht 10 verbundenen optoelektronischen Bauelemente 2 überbrückt werden kann. Das kann durch Bilden eines Bogens, insbesondere hohen Bogens, durch den Bonddraht 10 oder eine Omega-förmige Bonddrahtkontaktierung erreicht werden, wie in Fig. 1 und nachfolgenden Fig. 2, 3 und 4, angedeutet ist.

An den beiden gegenüberliegenden Enden weist die bandförmige Leuchtmittelvorrichtung 1 jeweils einen Kontaktanschluss oder elektrischen Kontakt 11 auf. Die elektrischen Kontakte 11 sind jeweils z.B. mit dem äußersten optoelektrischen Bauelement 2 über einen Bonddraht 10 verbunden.

Die bandförmige Leuchtmittelvorrichtung 1 kann neben den LEDs oder LED Chips 3 als optoelektronischen Bauelementen 2 auch noch wenigsten ein oder mehrere weitere elektronische Bauelemente 7, einschließlich weiterer optoelektronischer Bauelemente sowie Treiber, Dioden, insbesondere Zener-Dioden, Wandler usw., aufweisen. Des Weiteren kann die bandförmige Leuchtmittelvorrichtung 1 zusätzlich zumindest in einem Abschnitt oder vollständig mit einer nicht dargestellten, beispielsweise biegbaren Umhüllung aus einem Kunststoff, z.B. Silikon usw., oder einem anderen transparenten oder teiltransparente Material oder Materialkombination versehen werden. Diese Umhüllungen können zum mechanischen Schutz und/oder auch zur Umwandlung des Lichts hinsichtlich Farbe und/oder Spektrum ausgebildet oder vorgesehen sein.

Nach der Herstellung der in nachfolgenden Fig. 2, 3 und 4 gezeigten, flachen bandförmigen Leuchtmittelvorrichtung 1 kann diese z.B. durch Wickeln auf einen Kern oder dergleichen beispielsweise in eine Spiralform gebracht werden. Neben der Spiralform sind auch weitere Formen möglich, wie beispielsweise eine sternförmige, ovale, kreisförmige, runde, halbrunde und/oder eckige Form, je nach Funktion und Einsatzweck. Vorzugsweise sind die optoelektronischen Bauelemente 2, z.B. die LEDs oder LED Chips 3 in Fig. 1, bei dieser Anordnung in der Endform der bandförmigen Leuchtmittelvorrichtung 1 an der Außenseite des Substrats 4 angeordnet. Es sind aber auch andere Biegeverfahren möglich, wie z.B. ein kernloses Biegen auf einem Biegeautomat usw.. Die Erfindung ist jedoch auf die genannten Beispiele zum Formen der bandförmigen Leuchtmittelvorrichtung 1 von einer flachen oder ebenen Ausgangsform in eine räumliche oder dreidimensionale Endform nicht beschränkt. Es kann jedes andere Verfahren oder Kombination von Verfahren eingesetzt werden, welches oder welche geeignet sind die bandförmige Leuchtmittelvorrichtung 1 von ihrer Ausgangsform in die Endform umzuformen.

Nach der Verformung des Substrats 4 kann dieses optional durch zumindest ein teilweises oder vollständiges Aufbringen wenigstens eines weiteren nicht dargestellten transparenten oder teiltransparenten Materials oder Fixierungsmaterials zusätzlich fixiert werden. Beispielsweise handelt es sich bei dem Material, um ein Epoxidharz oder ein silikonhaltiges Material, welches nach dem Aufbringen aushärtet und die bandförmige Leuchtmittelvorrichtung 1 dadurch in seiner Endform fixiert.

Neben dieser mechanischen Fixierung durch das Auftragen wenigstens eines Fixierungsmaterials kann das Fixierungsmaterial auch als zusätzlicher mechanischer Schutz und/oder auch zur Umwandlung des Lichtest hinsichtlich Farbe und Spektrum dienen oder ausgebildet sein.

In Fig. 2 und 3 ist eine zweite Ausführungsform einer bandförmigen Leuchtmittelvorrichtung 1 in der Ausgangsform illustriert. Fig. 2 zeigt dabei eine Seitenansicht und Fig. 3 eine Draufsicht auf die bandförmige Leuchtmittelvorrichtung 1. In Fig. 3 sind hierbei die Bonddrähte 10 als Beispiel für Verbindungsleitungen aus Gründen der Übersichtlichkeit nicht dargestellt.

Das in Fig. 2 und 3 gezeigte Substrat 4 der bandförmigen Leuchtmittelvorrichtung 1 ist beispielsweise als ein streifenförmiges, längliches Substrat 4 ausgebildet.

Wie zuvor beschrieben, ist die bandförmige Leuchtmittelvorrichtung 1 mit dem Substrat 4 und den darauf vorgesehenen optoelektronischen Bauelementen 2 in der Ausgangsform zunächst als flaches oder ebenes Band ausgebildet, wie in Fig. 2 gezeigt ist.

Das streifenförmige, längliche Substrat 4 weist z.B. eine rechteckige längliche Form auf, wie in Fig. 3 gezeigt ist. Die Erfindung ist aber auf ein derartiges Substrat 4 mit einer rechteckigen länglichen Form nicht beschränkt.

So kann das Substrat 4 eine beliebe Form aufweisen, beispielsweise eine gebogene, wellige, zick-zackförmige, sternförmige und/oder ringförmige Form usw..

Ein wellenförmiges Substrat 4' ist dabei beispielhaft in Fig. 3 mit einer gestrichelten Linie stark vereinfacht dargestellt. Dabei sind die ersten Abschnitte 5' des wellenförmigen Substrats 4' jeweils in Form z.B. zweier schmaler Verbindungsstege 9' ausgebildet. Auf den zweiten Abschnitten 6' des Substrats 4' sind, wie mit einer gepunkteten Linie angedeutet, z.B. jeweils ein optoelektronisches Bauelement 2, wie ein LED-Chip 3 befestigt. Es kann aber auch ein anderes elektronisches Bauelement 7 oder auch mehr als ein elektronisches Bauelement 7 auf wenigstens einem der zweiten Abschnitte 6' befestigt sein. Ebenso kann auch ein zweiter Abschnitt 6' freigelassen werden, je nach Funktion und Einsatzzweck. Diese Ausführungen gelten für alle Ausführungsformen der Erfindung.

Auf diese Weise kann der Querschnitt des ersten Abschnitts 5' des Substrats 4 auf wenigstens einen oder zwei in der Breite verjüngte Verbindungsstege 9 bzw. 9' reduziert werden.

Auf dem länglichen Streifen sind in dem in Fig. 3 gezeigten Ausführungsbeispiel mehrere optoelektronische Bauelemente 2, z.B. LED-Chips 3, angeordnet. Wie in Fig. 2 und 3 gezeigt ist, sind die LED-Chips 3 fluchtend in einer Reihe in Längsrichtung des Substrats 4 angeordnet. Ebenso können die LED-Chips 6 auch in einer Reihe zumindest teilweise zueinander versetzt auf dem Substrat 4 angeordnet sein usw.. Des Weiteren können wie zuvor beschrieben, statt nur einem elektronischen Bauelement 7 auch mehrere elektronische Bauelemente 7 auf einem jeweils zweiten Abschnitt 6 des Substrats 4 vorgesehen werden.

Jeweils zwei benachbarte LED-Chips 3 sind über einen Bonddraht 10 als Verbindungsleitung miteinander elektrisch verbunden. Dabei enthält, wie in Fig. 3 gezeigt ist, jeder LED-Chip 3 zumindest zwei Kontaktanschlüsse A, K wobei einer dieser Anschlüsse der Anodenkontakt A und der andere Anschluss den Kathodenkontakt K bildet. Die elektrische Kontaktierung benachbarter LED-Chips 3 erfolgt jeweils mittels Bondkontakte durch Kontaktieren eines jeweiligen Anodenkontakts A eines ersten LED-Chips 3 mit einem Kathodenkontakt K eines zu diesem LED-Chip 3 benachbarten weiteren LED-Chip 3.

An den beiden gegenüberliegenden Enden weist die bandförmige Leuchtmittelvorrichtung 1 bzw. deren Substrat 4 jeweils einen Kontaktanschluss oder elektrischen Kontakt 11 auf. Die elektrischen Kontakte 11 sind jeweils mit den äußeren LED-Chips 3 über eine Verbindungsleitung, z.B. einen Bonddraht 10, verbunden.

Bei der zweiten Ausführungsform der Erfindung, ist wie zuvor beschrieben, der Querschnitt des Substrats 4 oder die Biegesteifigkeit im ersten Abschnitt 5 oder Bereich zwischen den optoelektronischen Bauelementen 2, hier z.B. LED-Chips 3, reduziert. Der jeweilige erste Abschnitt 5 oder der Bereich des Substrats 4 zwischen zwei benachbart angeordneten LED-Chips 3 und dem ersten Abschnitt 5 oder Bereich zwischen dem LED-Chip 3 und dem dazu benachbarten elektrischen Kontakt 11 sind dabei gemäß der zweiten Ausführungsform in der Breite reduziert.

Die Breite des Substrats 4 in dem ersten Abschnitt 5 oder Bereich zwischen den benachbarten optoelektronischen Bauelementen 2 kann dabei um mehr als 10% oder sogar um mehr als 50% reduziert werden.

In Fig. 4 ist eine Seitenansicht einer bandförmigen Leuchtmittelvorrichtung 1 gemäß einer dritten Ausführungsform der Erfindung dargestellt. Die bandförmige Leuchtmittelvorrichtung 1 ist dabei in der Ausgangsform gezeigt.

Die dritte Ausführungsform der bandförmigen Leuchtmittelvorrichtung 1 unterscheidet sich dabei von der zuvor mit Bezug auf die Fig. 2 und 3 beschriebenen zweiten Ausführungsform lediglich dadurch, dass der Querschnitt des Substrats 4 im ersten Abschnitt 5 oder zwischen jeweils zwei benachbarten auf dem Substrat 4 angeordneten optoelektronischen Bauelementen 2 und der Querschnitt des ersten Abschnitts 5 oder zwischen dem jeweiligen elektronischen Kontakt 11 und dem dazu benachbarten optoelektronischen Bauelement 2 wenigstens in der Dicke reduziert ist.

Wie zuvor des Weiteren mit Bezug auf Fig. 1 beschrieben wurde, sind die Verbindungsleitungen z.B. in Form von Bonddrähten 10, entsprechend in der Länge derart angepasst, dass sie ein Biegen des jeweils ersten Abschnitts 5 des Substrats 4 erlauben, ohne dass die Verbindungsleitungen zu den auf dem jeweils zweiten Abschnitt 6 des Substrats 4 angeordnete optoelektronischen Bauelementen 2 abreißen.

Fig. 5 zeigt ein Ausführungsbeispiel einer erfindungsgemäßen Lampe 12. Die Lampe 12 ist hier als so genannte Retrofit-Lampe ausgebildet, welche somit ein einer herkömmlichen Glühlampe vergleichbares Design aufweist. Im Unterschied zu einer herkömmlichen Glühlampe, bei der im Inneren der Hülle 14 ein Schutzgas zum Schutz des Glühfadens vorgesehen ist, fungiert bei der dieser Retrofit-Lampe der birnenähnliche Glaskolben zusammen mit dem darin enthaltenen Gas als Kühlmittel.

Ebenso kann in weiteren Ausführungsformen von Retrofit-Lampen, diese auch einen Kühlkörper aufweisen, der mit den LEDs der Lampe gekoppelt ist, um die durch die Vielzahl der verwendeten LEDs punktuell erzeugten Wärme abzuführen und um zu vermeiden, dass eine Überhitzung der LEDs deren Funktion und Lebensdauer negativ beeinflusst.

Der Sockel 15 der Lampe in Fig. 5, der mit der Hülle 14 verbunden ist, ist im vorliegenden Fall als Edison-Lampensockel ausgebildet. Beispielsweise kann hier ein E27-Sockel zur Verwendung für Allgebrauchslampen vorgesehen sein.

Ferner ist hier eine spiralförmig ausgebildete Leuchtmittelanordnung 16 vorgesehen. Als Leuchtmittelanordnung ist dabei eine bandförmige Leuchtmittelvorrichtung 1 gemäß einer der zuvor mit Bezug auf die Fig. 1 bis 4 beschriebenen Ausführungsformen einsetzbar. Diese spiralförmige Struktur ist dafür geeignet, analog zu einem herkömmlichen Glühfaden, Licht in alle Raumrichtungen, also in 4π-Richtung, auszusenden. Diese spiralförmige Leuchtmittelanordnung 1 kann beispielsweise durch einen biegbaren Draht als Substrat, den zuvor beschrieben biegbaren Streifen als Substrat oder einen biegbaren Halbleiterkörper als Substrat realisiert sein, auf dessen Oberfläche entsprechende LED-Bauelemente, welche in Fig. 5 nicht gezeigt sind, befestigt und miteinander elektrisch verbunden sind.

Insbesondere bei einem als biegbarer Draht ausgebildetem Substrat kann, wie bei dem zuvor mit Bezug auf Fig. 1 beschriebene Substrat, die mechanische Biegesteifigkeit im ersten Abschnitt oder im Bereich zwischen den optoelektronischen Bauelementen, z.B. LED Chips, reduziert werden durch Änderung der Materialeigenschaften, beispielsweise mittels Weichglühen des ersten Abschnitts.

Ebenso kann insbesondere bei einem als Halbleiterkörper ausgebildeten Substrat, wie bei der Ausführungsform in Fig. 2 und 3 sowie der Ausführungsform in Fig. 4, der Querschnitt des ersten Abschnitts in Breitenrichtung und/oder Dickenrichtung reduziert werden, um die mechanische Biegesteifigkeit des Substrats in den ersten Abschnitten zu reduzieren, die mit den zweiten Abschnitten und deren optoelektronischen Bauelemente verbunden sind.

Auf dem zuvor mit Bezug auf die Fig. 1 bis 4 beschriebenen Substrat sind eine Vielzahl von LED-Chips angeordnet. Diese LED-Chips sind in dem Substrat eingebracht, auf dessen Oberfläche aufgebracht, dort befestigt oder in eigens dafür vorgesehene Ausnehmungen im Substrat angeordnet und befestigt. Die Befestigung der LED-Chips kann beispielsweise mittels einer Klebeschicht, einer Bondverbindung, einer adhäsiven oder befestigten Verbindungen, Löten oder dergleichen erfolgen.

Jedes dieser LED-Chips umfasst zumindest ein LED-Halbleiterbauelement. Jeder LED-Chip ist somit dazu ausgebildet, entsprechend der physikalischen Eigenschaften des verwendeten Halbleitermaterials und dessen Dotierung Licht einer bestimmten Wellenlänge auszusenden.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar. Insbesondere sind die zuvor beispielhaft mit Bezug auf die Fig. 1 bis 4 beschriebenen Ausführungsformen für eine bandförmige Leuchtmittelvorrichtung auch miteinander kombinierbar, besonders einzelne Merkmale davon.

Bei den zuvor beschriebenen Ausführungsformen der bandförmigen Leuchtmittelvorrichtung ist das Substrat beispielsweise aus Metall, wie z.B. einem Nichteisenmetall, einem mehrlagigen Metallstreifen oder einer Kombination aus Metall und Kunststoff hergestellt.

Ebenso kann das Substrat auch als Halbleitersubstrat oder Halbleiterkörper ausgebildet sein. In diesem Falle können die optoelektronischen Bauelemente, z.B. die zuvor beschriebenen LEDs oder LED-Chips, unmittelbar im Halbleiterkörper des Substrats, beispielsweise durch Diffusion und Implantation, eingebracht werden. Dies ist aus herstellungstechnischer Sicht besonders vorteilhaft, jedoch ist hier für den ansonsten brüchigen Halbleiterkörper des Substrats unter Umständen ein zusätzlicher Träger erforderlich, welcher das Substrat stabilisiert. Alternativ ist das als Halbleiterkörper ausgebildete Substrat derart dünn ausgebildet, dass es biegsam ist und beispielsweise auf einer flexiblen Folie befestigbar ist. Dem entsprechend kann eine bandförmige Leuchtmittelvorrichtung mit einem z.B. streifenförmigen Halbleiterkörper ausgebildet werden, welcher dreidimensional oder räumlich geformt ist, beispielsweise derart, dass auf ihm als Substrat befestige optoelektronische Bauelemente, z.B. LED-Chips, in alle Raumrichtungen strahlen oder wirken.

Insbesondere ist die vorliegende Erfindung nicht auf Retrofit-Lampen mit Edison-Sockel beschränkt. Beispielsweise kann auch eine andere Sockelart, wie etwa ein Stecksockel, Bajonettsockel, Zweistiftstecksockel und dergleichen, verwenden werden. Grundsätzlich wären auch so genannte sockellose Lampen denkbar, bei denen der Sockel über Kontaktdrähte realisiert ist.

Auch die Form der Hülle der Lampe ist nicht auf ein birnenförmiges Glühlampen-ähnliches Design beschränkt, sondern kann beliebig ausgebildet sein.

### Bezugszeichenliste

- 1: bandförmige Leuchtmittelvorrichtung
- 2: optoelektronisches Bauelement
- 3: LED-Chip
- 4: Substrat
- 5: erster Abschnitt
- 6: zweiter Abschnitt
- 7: elektronisches Bauelement
- 8: Biegeradius
- 9: Verbindungssteg
- 10: Bonddraht
- 11: elektrischer Kontakt
- 12: Lampe
- 14: Hülle
- 15: Sockel
- 16: Leuchtmittelanordnung

## Patentansprüche

1. Bandförmige Leuchtmittelvorrichtung (1) für eine Lampe (12), insbesondere LED-Lampe, aufweisend:
ein Substrat (4), welches einen ersten Abschnitt (5, 5') und wenigstens einen zweiten Abschnitt (6, 6') bildet, wobei der erste Abschnitt (5, 5') gegenüber dem zweiten Abschnitt (6, 6') eine reduzierte Biegesteifigkeit aufweist durch Aufbringen wenigstens eines zusätzlichen Materials auf den wenigstens einen zweiten Abschnitt (6, 6'), wobei die bandförmige Leuchtmittelvorrichtung (1) in dem wenigstens einen ersten Abschnitt (5, 5') mit der reduzierten Biegesteifigkeit derart gebogen ist, dass eine ebene Ausgangsform der bandförmigen Leuchtmittelvorrichtung (1) eine dreidimensionale Endform annimmt, wobei die Leuchtmittelvorrichtung (1) wenigstens ein optoelektronisches Bauelement (2) aufweist, welches auf dem wenigstens einen zweiten Abschnitt (6, 6') angeordnet ist, **dadurch gekennzeichnet, dass** die bandförmige Leuchtmittelvorrichtung (1) eine Hülle aufweist, die steif oder biegsam ausgebildet ist.

2. Bandförmige Leuchtmittelvorrichtung (1) nach Anspruch 1, **dadurch gekennzeichnet,**
**dass** das optoelektronische Bauelement (2) ein LED-Chip (3) ist, und wobei der wenigstens eine zweite Abschnitt (6, 6') vorzugsweise ungebogen oder im Wesentlichen ungebogen bleibt.

3. Bandförmige Leuchtmittelvorrichtung (1) nach einem der vorstehenden Ansprüche,
**dadurch gekennzeichnet,**
**dass** der wenigstens eine erste Abschnitt (5, 5') plastisch verformbar und/oder elastisch verformbar ist und wobei zumindest der elastisch verformte erste Abschnitt (5, 5') durch ein Fixierungsmittel in seiner gebogenen Form fixierbar ist, wobei das Fixierungsmittel vorzugsweise zumindest teiltransparent und aushärtbar ist, und wobei das Fixierungsmittel insbesondere aus Epoxidharz, Silikon oder einem silikonhaltigen Material besteht und/oder
wobei das Substrat (4) als Streifen, Draht oder Halbleiterelement ausgebildet ist.

4. Bandförmige Leuchtmittelvorrichtung (1) nach einem der vorstehenden Ansprüche, **dadurch gekennzeichnet,**
**dass** das Substrat (4) aus Metall, einer Metalllegierung, einem mehrlagigen Metallstreifen, und/oder einem Kunststoff hergestellt ist und wobei das Substrat (4) vorzugsweise eine hohe Wärmeleitfähigkeit besitzt.

5. Bandförmige Leuchtmittelvorrichtung (1) nach einem der vorstehenden Ansprüche,
**dadurch gekennzeichnet,**
**dass** der erste Abschnitt (5, 5') zwischen zwei zweiten Abschnitten (6, 6') vorgesehen ist, wobei wenigstens einer der zweiten Abschnitte (6, 6') vorzugsweise wenigstens ein zusätzliches elektronisches Bauelement (7) aufweist, und/oder dass der erste Abschnitt (5, 5') mit einem reduzierten Querschnitt ausgebildet ist, wobei der Querschnitt des ersten Abschnitts (5, 5') in der Breite und/oder der Dicke reduziert ist zum Ausbilden des ersten Abschnitts (5, 5') mit der reduzierten Biegesteifigkeit.

6. Bandförmige Leuchtmittelvorrichtung (1) nach Anspruch 5, **dadurch gekennzeichnet,**
**dass** der Querschnitt des ersten Abschnitts (5, 5') des Substrats (4) in seiner Breite und/oder Dicke gegenüber dem zweiten Abschnitt (6, 6') des Substrats (4) um wenigstens 10% und vorzugsweise um wenigstens 50% reduziert ist oder dass die Biegesteifigkeit des wenigstens einen ersten Abschnitts (5, 5') des Substrats (4) gegenüber der Biegesteifigkeit des wenigstens einen zweiten Abschnitts (6, 6') um mindestens 10% und vorzugsweise um mindestens 50% reduziert ist.

7. Bandförmige Leuchtmittelvorrichtung (1) nach einem der vorstehenden Ansprüche, **dadurch gekennzeichnet,**
**dass** die Biegesteifigkeit des wenigstens einen ersten Abschnitts (5, 5') gegenüber der Biegesteifigkeit des wenigstens einen zweiten Abschnitts (6, 6') des Substrats (4) reduziert ist durch Ändern der Materialeigenschaft des ersten Abschnitts oder zweiten Abschnitts (6, 6').

8. Bandförmige Leuchtmittelvorrichtung (1) nach einem der vorstehenden Ansprüche, **dadurch gekennzeichnet,**
**dass** die Biegesteifigkeit des wenigstens einen ersten Abschnitts (5, 5') gegenüber der Biegesteifigkeit des wenigstens einen zweiten Abschnitts (6, 6') des Substrats (4) aus Metall oder einer Metalllegierung durch Weichglühen geändert ist.

9. Bandförmige Leuchtmittelvorrichtung (1) nach einem der vorstehenden Ansprüche, **dadurch gekennzeichnet,**
**dass** die Biegesteifigkeit des wenigstens einen zweiten Abschnitts (6, 6') gegenüber der Biegesteifigkeit des wenigstens einen ersten Abschnitts (5, 5') des Substrats (4) erhöht ist durch Aufbringen wenigstens eines zusätzlichen Materials auf den wenigstens einen zweiten Abschnitt (6, 6'), wobei das zusätzliche Material insbesondere Metall, Kunststoff, vorzugsweise eine Kunststofffolie oder Kunststoffbeschichtung, oder Keramik ist und wobei das zusätzliche Material vorzugsweise elektrisch isolierend und derart auf dem wenigstens einen zweiten Abschnitt aufgebracht ist, mindestens ein auf dem zweiten Abschnitt (6, 6') vorgesehenes optoelektronisches Element (2) gegenüber dem Substrat (4) elektrisch zu isolieren.

10. Bandförmige Leuchtmittelvorrichtung (1) nach einem der vorstehenden Ansprüche,
**dadurch gekennzeichnet,**
**dass** der wenigstens eine erste Abschnitt (5, 5') in Form eines oder mehrerer Verbindungsstege (9, 9') zwischen zwei zweiten Abschnitten (6, 6') ausgebildet ist, die mit den Enden des ersten Abschnitts (5, 5') verbunden sind, und/oder dass die bandförmige Leuchtmittelvorrichtung (1) als eine dreidimensionale Endform eine Spiralform, eine runde Form, eine Sternform, eine ovale Form und/oder eine eckige Form aufweist.

11. Bandförmige Leuchtmittelvorrichtung (1) nach einem der vorstehenden Ansprüche, **dadurch gekennzeichnet,**
**dass** die bandförmige Leuchtmittelvorrichtung (1) an ihren Enden jeweils einen elektrischen Kontakt (11) aufweist, wobei wenigstens ein elektrischer Kontakt (11) mit dem wenigstens einen optoelektronischen Bauelement (2) durch eine Verbindungsleitung elektrisch verbunden ist, wobei die Verbindungsleitung insbesondere ein Bonddraht (10) oder eine Leiterbahn des Substrats (4) ist und/oder
**dass** wenigstens zwei optoelektronische Bauelemente (2) durch eine Verbindungsleitung miteinander elektrisch verbunden sind, wobei die Verbindungsleitung insbesondere ein Bonddraht (10) oder eine Leiterbahn des Substrats (4) ist.

12. Lampe (12) mit wenigstens einer bandförmigen Leuchtmittelvorrichtung (1) nach einem der Ansprüche 1 bis 11, wobei die Lampe (12) vorzugsweise eine LED-Lampe und insbesondere eine Retrofit-Lampe ist, und wobei die Lampe (12) wenigstens einen LED-Chip (3) als optoelektronisches Bauelement (2) aufweist.

13. Verfahren zur Herstellung einer bandförmigen Leuchtmittelvorrichtung (1) nach einem der Ansprüche 1 bis 11, wobei das Verfahren die Schritte aufweist:
Bereitstellen einer ebenen bandförmigen Leuchtmittelvorrichtung (1) als Ausgangsform, wobei die bandförmige Leuchtmittelvorrichtung (1) ein Substrat (4) aufweist, welches wenigstens einen ersten Abschnitt (5, 5') und wenigstens einen zweiten Abschnitt (6, 6') bildet,
Ausbilden des wenigstens einen ersten Abschnitts (5, 5') mit einer gegenüber dem wenigstens einen zweiten Abschnitt (6, 6') reduzierten Biegesteifigkeit durch Aufbringen wenigstens eines zusätzlichen Materials auf den wenigstens einen zweiten Abschnitt (6, 6'),
Aufbringen wenigstens eines optoelektronischen Bauelements (2) auf einen der zweiten Abschnitte (6, 6'); und
Biegen des wenigstens einen ersten Abschnitts (5, 5') derart, dass die ebene bandförmige Leuchtmittelvorrichtung (1) eine dreidimensionale Endform annimmt.

14. Verfahren nach Anspruch 13,
**gekennzeichnet durch** die Schritte:
Bereitstellen eines ebenen Substrats (4), welches den wenigstens einen ersten Abschnitt (5, 5') und den wenigstens einen zweiten Abschnitt (6, 6') bildet, wobei das ebene Substrat (4) eine rechteckige, runde, ovale, wellenförmige und/oder zickzackförmige Form aufweist;
Ausbilden des wenigstens einen ersten Abschnitts (5, 5') mit einer reduzierten Biegesteifigkeit gegenüber dem zweiten Abschnitt (6, 6') **durch** Reduzieren der Breite und/oder Dicke des wenigstens einen ersten Abschnitts (5, 5') und/oder durch Ändern der Materialeigenschaft des wenigstens einen ersten Abschnitts (5, 5') derart, dass der wenigstens eine erste Abschnitt (5, 5') die reduzierte Biegesteifigkeit gegenüber dem wenigstens einen zweiten Abschnitt (6, 6') aufweist;
und
Biegen des wenigstens einen ersten Abschnitts (5, 5') derart, dass die ebene bandförmige Leuchtmittelvorrichtung (1) die dreidimensionale Endform annimmt, wobei das Biegen des wenigstens einen ersten Abschnitts (5, 5') vorzugsweise mittels eines Kerns oder kernlos **durch** einen Biegeautomat erfolgt.

## Claims

1. Band-shaped illuminant device (1) for a lamp (12), particularly for an LED lamp, having:
a substrate (4), which comprises a first portion (5, 5') and at least a second portion (6, 6'), wherein in comparison with the second portion (6, 6') the first portion (5, 5') has reduced bending stiffness by application of at least one additional material to the at least one second portion (6, 6'), wherein the band-shaped illuminant device (1) in the at least one first portion (5, 5') with reduced bending stiffness is bent such that a flat starting shape of the band-shaped illuminant device (1) assumes a three-dimensional final shape, wherein the illuminant device (1) has at least one optoelectronic component (2) arranged on the at least one second portion (6, 6'), **characterised in that** the band-shaped illuminant device (1) has an envelope which is stiff or flexible.

2. Band-shaped illuminant device (1) according to claim 1, **characterised in**
**that** the optoelectronic component (2) is an LED chip (3), and wherein the at least one second portion (6, 6') remains preferably unbent or substantially unbent.

3. Band-shaped illuminant device (1) according to any one of the preceding claims,
**characterised in**
**that** the at least one first portion (5, 5') is plastically deformable and/or elastically deformable and wherein at least the elastically deformed first portion (5, 5') is fixable in its bent shape by means of a fixing agent, the fixing agent preferably being at least partly transparent and curable, and consisting in particular of epoxy resin, silicone or a silicone-containing material and/or the substrate (4) being provided as a strip, wire or semiconductor component.

4. Band-shaped illuminant device (1) according to any one of the preceding claims,
**characterised in**
**that** the substrate (4) is manufactured of metal, a metal alloy, a multi-ply metal strip, and/or a plastic and wherein the substrate (4) preferably is of high thermal conductivity.

5. Band-shaped illuminant device (1) according to any one of the preceding claims,
**characterised in**
**that** the first portion (5, 5') is provided between two second portions (6, 6'), wherein at least one of the second portions (6, 6') preferably has at least one additional electronic component (7), and/or in that the first portion (5, 5') has a reduced cross-section, the cross-section of the first portion (5, 5') being reduced in width and/or thickness for providing the first portion (5, 5') with reduced bending stiffness.

6. Band-shaped illuminant device (1) according to claim 5, **characterised in**
**that** in comparison with the second portion (6, 6') of the substrate (4) the cross-section of the first portion (5, 5') of the substrate (4) is reduced in width and/or thickness by at least 10% and preferably by at least 50%, or in that in comparison with the bending stiffness of the at least one second portion (6, 6') the bending stiffness of the at least one first portion (5, 5') of the substrate (4) is reduced by at least 10% and preferably by at least 50%.

7. Band-shaped illuminant device (1) according to any one of the preceding claims,
**characterised in**
**that** in comparison with the bending stiffness of the at least one second portion (6, 6') the bending stiffness of the at least one first portion (5, 5') of the substrate (4) is reduced by altering the physical property of the first portion or second portion (6, 6').

8. Band-shaped illuminant device (1) according to any one of the preceding claims,
**characterised in**
**that** in comparison with the bending stiffness of the at least one second portion (6, 6') comprising metal or a metal alloy the bending stiffness of the at least one first portion (5, 5') of the substrate (4) is altered by means of soft annealing.

9. Band-shaped illuminant device (1) according to any one of the preceding claims,
**characterised in**
**that** in comparison with the bending stiffness of the at least one first portion (5, 5') the bending stiffness of the at least one second portion (6, 6') of the substrate (4) is increased by applying at least one additional material to the at least one second portion (6, 6'), wherein the additional material is in particular metal, plastic, preferably a plastic film or plastic coating, or ceramic and wherein the additional material is preferably electrically insulating and is placed in such a way on the at least second portion in order to electrically insulate at least one optoelectronic component (2) provided on the second portion (6, 6') from the substrate (4).

10. Band-shaped illuminant device (1) according to any one of the preceding claims,
**characterised in**
**that** the at least one first portion (5, 5') is provided as one or a plurality of connecting webs (9, 9') between two second portions (6, 6') which are connected to the ends of the first portion (5, 5'), and/or in that the band-shaped illuminant device (1) in three-dimensional final shape comprises a spiral shape, a round shape, a star shape, an oval shape and/or an angular shape.

11. Band-shaped illuminant device (1) according to any one of the preceding claims,
**characterised in**
**that** at each of its ends the band-shaped illuminant device (1) has an electrical contact (11), wherein at least one electrical contact (11) is electrically connected to the at least one optoelectronic component (2) by means of a connecting lead, the connecting lead being in particular a bonding wire (10) or a printed conductor of the substrate (4), and/or in that at least two optoelectronic components (2) are electrically interconnected by means of a connecting lead, the connecting lead being in particular a bonding wire (10) or a printed conductor of the substrate (4).

12. Lamp (12) with at least one band-shaped illuminant device (1) according to any one of claims 1 to 11, the lamp (12) preferably being an LED lamp, in particular a retrofit lamp, and wherein the lamp (12) has at least one LED chip (3) as an optoelectronic component (2).

13. Method of manufacturing a band-shaped illuminant device (1) according to any one of claims 1 to 11, wherein the method has the following steps:
providing a flat band-shaped illuminant device (1) as the starting shape, wherein the band-shaped illuminant device (1) has a substrate (4) which comprises at least one first portion (5, 5') and at least one second portion (6, 6');
constructing the at least one first portion (5, 5') with reduced bending stiffness in comparison with the at least one second portion (6, 6') by applying at least one additional material to the at least one second portion (6, 6');
applying at least one optoelectronic component (2) to one of the second portions (6, 6'); and
bending the at least one first portion (5, 5') such that the flat band-shaped illuminant device (1) assumes a three-dimensional final shape.

14. Method according to claim 13, **characterised by** the following steps:
providing a flat substrate (4), which forms the at least one first portion (5, 5') and the at least one second portion (6, 6'), wherein the flat substrate (4) has a rectangular, round, oval, wavy and/or zig-zag shape;
constructing the at least one first portion (5, 5') with reduced bending stiffness in comparison with the second portion (6, 6') by reducing the width and/or thickness of the at least one first portion (5, 5') and/or by altering the physical property of the at least one first portion (5, 5') such that the at least one first portion (5, 5') has reduced bending stiffness in comparison with the at least one second portion (6, 6');
and
bending the at least one first portion (5, 5') such that the flat band-shaped illuminant device (1) assumes the three-dimensional final shape, wherein the bending of the at least one first portion (5, 5') is achieved preferably by the use of a core or corelessly by means of a bending machine.

## Revendications

1. Dispositif d'éclairage (1) en forme de bande destiné à une lampe (12), en particulier une lampe à LED, comportant :
un substrat (4), qui forme au moins une première partie (5, 5') et au moins une seconde partie (6, 6'), la première partie (5, 5') présentant une rigidité à la flexion réduite par rapport à la seconde partie (6, 6') par l'application d'au moins un matériau supplémentaire sur l'au moins une seconde partie (6, 6'), le dispositif d'éclairage (1) en forme de bande étant plié dans l'au moins une première partie (5, 5') à la rigidité à la flexion réduite de telle manière qu'une forme initiale plane du dispositif d'éclairage (1) en forme de bande prend une forme finale tridimensionnelle, le dispositif d'éclairage (1) comportant au moins un composant optoélectronique (2), qui est disposé sur l'au moins une seconde partie (6, 6'), **caractérisé en ce que**
le dispositif d'éclairage (1) en forme de bande comporte une enveloppe, qui est réalisée rigide ou flexible.

2. Dispositif d'éclairage (1) en forme de bande selon la revendication 1,
**caractérisé en ce**
**que** le composant optoélectronique (2) est une puce LED (3), et dans lequel l'au moins une seconde partie (6, 6') reste de préférence non pliée ou sensiblement non pliée.

3. Dispositif d'éclairage (1) en forme de bande selon l'une des revendications précédentes,
**caractérisé en ce**
**que** l'au moins une première partie (5, 5') est capable de subir une déformation plastique et/ou élastique et dans lequel au moins la première partie (5, 5') ayant subi une déformation élastique peut être fixée dans sa forme pliée par un moyen de fixation, le moyen de fixation étant de préférence au moins partiellement transparent et durcissable, et le moyen de fixation étant constitué en particulier de résine époxyde, de silicone ou d'un matériau contenant de la silicone et/ou
le substrat (4) étant réalisé sous la forme d'une bande, d'un fil métallique ou d'un élément semi-conducteur.

4. Dispositif d'éclairage (1) en forme de bande selon l'une des revendications précédentes,
**caractérisé en ce**
**que** le substrat (4) est fabriqué en métal, en alliage métallique, en une bande métallique à plusieurs couches, et/ou en matière plastique et le substrat (4) ayant de préférence une conductibilité thermique élevée.

5. Dispositif d'éclairage (1) en forme de bande selon l'une des revendications précédentes,
**caractérisé en ce**
**que** la première partie (5, 5') est prévue entre deux secondes parties (6, 6'), au moins une des secondes parties (6, 6') comportant de préférence au moins un composant électronique (7) supplémentaire, et/ou en ce que la première partie (5, 5') est réalisée avec une section transversale réduite, la section transversale de la première partie (5, 5') étant réduite en largeur et/ou en épaisseur pour former la première partie (5, 5') dotée de la rigidité en flexion réduite.

6. Dispositif d'éclairage (1) en forme de bande selon la revendication 5,
**caractérisé en ce**
**que** la section transversale de la première partie (5, 5') du substrat (4) est réduite dans sa largeur et/ou son épaisseur d'au moins 10 % et de préférence d'au moins 50 % par rapport à la seconde partie (6, 6') du substrat (4) ou en ce que la rigidité à la flexion de l'au moins une première partie (5, 5') du substrat (4) est réduite d'au moins 10 % et de préférence d'au moins 50 % par rapport à la rigidité à la flexion de l'au moins une seconde partie (6, 6').

7. Dispositif d'éclairage (1) en forme de bande selon l'une des revendications précédentes,
**caractérisé en ce**
**que** la rigidité à la flexion de l'au moins une première partie (5, 5') est réduite par rapport à la rigidité à la flexion de l'au moins une seconde partie (6, 6') du substrat (4) en modifiant les propriétés du matériau de la première partie ou de la seconde partie (6, 6').

8. Dispositif d'éclairage (1) en forme de bande selon l'une des revendications précédentes,
**caractérisé en ce**
**que** la rigidité à la flexion de l'au moins une première partie (5, 5') est modifiée par rapport à la rigidité à la flexion de l'au moins une seconde partie (6, 6') du substrat (4) en métal ou alliage métallique par recuit d'adoucissement.

9. Dispositif d'éclairage (1) en forme de bande selon l'une des revendications précédentes,
**caractérisé en ce**
**que** la rigidité à la flexion de l'au moins une seconde partie (6, 6') est augmentée par rapport à la rigidité à la flexion de l'au moins une première partie (5, 5') du substrat (4) par l'application d'au moins un matériau supplémentaire sur l'au moins une seconde partie (6, 6'), le matériau supplémentaire étant en particulier du métal, de la matière plastique, de préférence une feuille en matière plastique ou un revêtement en matière plastique, ou de la céramique et le matériau supplémentaire étant de préférence isolant électriquement et appliqué sur l'au moins une seconde partie de manière à isoler électriquement au moins un élément optoélectronique (2) prévu sur la seconde partie (6, 6') par rapport au substrat (4).

10. Dispositif d'éclairage (1) en forme de bande selon l'une des revendications précédentes,
**caractérisé en ce**
**que** l'au moins une première partie (5, 5') est réalisée sous la forme d'un ou de plusieurs éléments de liaison (9, 9') entre deux secondes parties (6, 6'), qui sont reliés aux extrémités de la première partie (5, 5'), et/ou en ce que le dispositif d'éclairage (1) en forme de bande présente, comme forme finale tridimensionnelle, une forme de spirale, une forme ronde, une forme d'étoile, une forme ovale et/ou une forme polygonale.

11. Dispositif d'éclairage (1) en forme de bande selon l'une des revendications précédentes,
**caractérisé en ce**
**que** le dispositif d'éclairage (1) en forme de bande comporte sur ses extrémités respectivement un contact électrique (11), au moins un contact électrique (11) étant relié électriquement à l'au moins un composant optoélectronique (2) par une ligne de connexion, la ligne de connexion étant en particulier un fil de connexion (10) ou une piste conductrice du substrat (4) et/ou
en ce qu'au moins deux composants optoélectroniques (2) sont reliés électriquement entre eux par une ligne de connexion, la ligne de connexion étant en particulier un fil de connexion (10) ou une piste conductrice du substrat (4).

12. Lampe (12) comprenant au moins un dispositif d'éclairage (1) en forme de bande selon l'une des revendications 1 à 11, la lampe (12) étant de préférence une lampe à LED et en particulier une lampe « retrofit », et la lampe (12) comportant au moins une puce LED (3) en guise de composant optoélectronique (2).

13. Procédé de fabrication d'un dispositif d'éclairage (1) en forme de bande selon l'une des revendications 1 à 11, le procédé comportant les étapes consistant à :
mettre à disposition un dispositif d'éclairage (1) plan en forme de bande en guise de forme initiale, le dispositif d'éclairage (1) en forme de bande comportant un substrat (4), qui forme au moins une première partie (5, 5') et au moins une seconde partie (6, 6'),
former l'au moins une première partie (5, 5') avec une rigidité à la flexion réduite par rapport à l'au moins une seconde partie (6, 6') par l'application d'au moins un matériau supplémentaire sur l'au moins une seconde partie (6, 6'),
appliquer au moins un composant optoélectronique (2) sur une des secondes parties (6, 6') ; et
plier l'au moins une première partie (5, 5') de telle manière que le dispositif d'éclairage (1) plan en forme de bande prenne une forme finale tridimensionnelle.

14. Procédé selon la revendication 13,
**caractérisé par** les étapes consistant à :
mettre à disposition un substrat (4) plan, qui forme l'au moins une première partie (5, 5') et l'au moins une seconde partie (6, 6'), le substrat (4) plan présentant une forme rectangulaire, ronde, ovale, ondulée et/ou en zigzag ;
former l'au moins une première partie (5, 5') avec une rigidité à la flexion réduite par rapport à la seconde partie (6, 6') en réduisant la largeur et/ou l'épaisseur de l'au moins une première partie (5, 5') et/ou en modifiant les propriétés du matériau de l'au moins une première partie (5, 5') de telle manière que l'au moins une première partie (5, 5') présente la rigidité à la flexion réduite par rapport à l'au moins une seconde partie (6, 6') ; et
plier l'au moins une première partie (5, 5') de telle manière que le dispositif d'éclairage (1) plan en forme de bande prend la forme finale tridimensionnelle, le pliage de l'au moins une première partie (5, 5') étant effectué de préférence au moyen d'une matrice ou sans matrice par une machine à plier automatique.
